# EUROPÄISCHE PATENTSCHRIFT

(11) **EP 1 307 604 B1**
(45) Veröffentlichungstag und Bekanntmachung des Hinweises auf die Patenterteilung: **06.05.2004**
(21) Anmeldenummer: 01960643.3
(22) Anmeldetag: 09.08.2001
(51) Int. Cl.: C23C 14/04, C03C 17/25, C03C 19/00, C03B 11/08

(54) **VERFAHREN ZUR HERSTELLUNG EINES WERKZEUGS DAS ZUR SCHAFFUNG VON OBERFLÄCHENSTRUKTUREN IM SUB-MIKROMETER BEREICH EINSETZBAR IST**
METHOD FOR PRODUCING A TOOL WHICH CAN BE USED TO CREATE SURFACE STRUCTURES IN THE SUB-MICROMETER RANGE
PROCEDE DE FABRICATION D'UN OUTIL POUVANT ETRE EMPLOYE POUR LA REALISATION DE STRUCTURES DE SURFACE DANS LE DOMAINE SOUS-MICROMETRE

(30) Priorität: 10.08.2000 DE 10039208
(43) Veröffentlichungstag der Anmeldung: 07.05.2003
(73) Patentinhaber: Fraunhofer-Gesellschaft zur Förderung der angewandten Forschung e.V., 80686 München (DE)
(72) Erfinder: BURMEISTER, Frank, 79194 Gundelfingen (DE); DÖLL, Walter, 79276 Reute (DE); KLEER, Günter, 79256 Buchenbach (DE)
(74) Vertreter: Rösler, Uwe, Dipl.-Phys.
(86) Internationale Anmeldenummer: PCT/EP2001/009232
(87) Internationale Veröffentlichungsnummer: WO 2002/012586

(56) Entgegenhaltungen:
- WO-A-97/39159
- GB-A- 653 396
- US-A- 4 865 873
- PATENT ABSTRACTS OF JAPAN vol. 2000, no. 06, 22. September 2000 (2000-09-22) & JP 2000 071290 A (TEIJIN LTD), 7. März 2000 (2000-03-07)
- SAKAMOTO Y ET AL: "Fabrication of a micro-patterned diamond film by site-selective plasma chemical vapor deposition" THIN SOLID FILMS, ELSEVIER-SEQUOIA S.A. LAUSANNE, CH, Bd. 334, Nr. 1-2, 4. Dezember 1998 (1998-12-04), Seiten 161-164, XP004157868 ISSN: 0040-6090
- PATENT ABSTRACTS OF JAPAN vol. 1995, no. 01, 28. Februar 1995 (1995-02-28) & JP 06 279036 A (MATSUSHITA ELECTRIC IND CO LTD), 4. Oktober 1994 (1994-10-04)

## Beschreibung

### Technisches Gebiet

Die Erfindung bezieht sich auf ein Verfahren zur Herstellung eines Werkzeuges, das zur Schaffung optisch wirksamer Oberflächenstrukturen im sub-µm Bereich verwendbar ist, mit einer Trägeroberfläche, auf der mittels Materialabscheidung erhabene Oberflächenstrukturen aufgebracht werden. Ferner wird ein diesbezügliches Werkzeug beschrieben.

### Stand der Technik

Bei einer Vielzahl lichtoptischer Anwendungen wirken sich Reflexionen des Lichtes an technischen sowie optischen Oberflächen und Grenzflächen störend bzw. energiemindemd aus. So wird beispielsweise die Ablesbarkeit von Displays durch Spiegelung externer Lichtquellen deutlich beeinträchtigt. Ferner treten bei verglasten Solarzellenmodule Reflexionsverluste an der Abdeckung auf, wodurch die Effizienz der Solarzelle erheblich verringert wird.

Zur Reflexionsminderung bzw. Transmissionserhöhung werden bisher in an sich bekannter Weise technisch aufwendige Einfach- sowie Mehrlagenschichtsysteme auf die Oberflächen zu Zwecken ihrer Entspiegelung aufgebracht. Diese Oberflächenvergütungen sind zum einen verhältnismäßig teuer, zum anderen in ihrer Funktion unbefriedigend, da ihre Wirkung stark vom Einfallswinkel sowie der Wellenlänge des auf die Oberflächen einfallenden Lichtes abhängt.

Neuere Methoden zur Entspiegelung verfolgen einen anderen Ansatz, nämlich den Übergang im Brechungsindex an der Oberfläche der jeweiligen optischen Komponente nicht wie bisher abrupt, sondern kontinuierlich zu gestalten. Hierzu wird die jeweilige Oberfläche "aufgerauht" bzw. strukturiert, um den aus der Natur bekannten Mottenaugeneffekt nachzuahmen. Bei der Ausbildung derartiger Oberflächenstrukturen müssen die mittleren lateralen Dimensionen der einzelnen Strukturen deutlich kleiner sein als die Wellenlänge des einfallenden Lichtes, um eine Streuung des Lichtes und damit einhergehend, eine Erhöhung der diffusen Reflexion zu vermeiden. Ferner ist es notwendig, dass die Strukturen für eine wirksame Reflexionsminderung ein Aspektverhältnis, d. h. das Verhältnis zwischen der vertikalen zur lateralen Abmessung der Oberflächenstrukturen, in der Größenordnung von 1 oder höher besitzen.

Die Herstellung derartiger Oberflächenstrukturen lässt sich mit geeignet geformten Werkzeugoberflächen im Wege von Heißpräge- oder Spritzgießprozessen realisieren, indem bspw. ein optisches Element zur Oberflächenvergütung mittels Heißprägen bis deutlich über die Glastemperatur des Materials, aus dem es besteht, erhitzt wird und mittels eines Prägewerkzeuges, das die Mikrostrukturierung im Negativabbild aufweist, an seiner Oberfläche entsprechend strukturiert wird. Derartige Prägewerkzeuge mit einem mikrostrukturierten Prägestempel können mittels galvanischer Methoden aus Nickel hergestellt werden, wobei periodische Oberflächenmikrostrukturen mit photolithographischen Techniken erzielt werden können. Derartige periodische Oberflächenstrukturen sind in ihrer optischen Wirkung sehr effizient und bisher bekannten stochastisch verteilten Mikrostrukturoberflächen in ihrer Effizienz weit überlegen, weisen aber den Nachteil auf, dass ihr Herstellungsprozess an das Material Nickel gebunden ist. Derartige, auch als "Master" bezeichnete Prägestempel verfügen materialbedingt jedoch nur über eine geringe Hochtemperaturbeständigkeit, wodurch sie lediglich für die Oberflächenformung von organischen Gläsern eingesetzt werden können, wie beispielsweise aus PMMA gefertigte, optische Elemente. Überdies weisen derartige Nickel-Masterwerkzeuge nur eine geringe Lebensdauer auf, da ein deutlicher materialbedingter Verschleiß durch den wiederholten Einsatz zu beobachten ist. Schließlich besitzt die Herstellungsmethode periodischer Strukturen unter Verwendung der Photolithographie den Nachteil, dass keine Freiformflächen oder asphärische Flächen, die sehr häufig in der Technik verlangt werden, strukturiert werden können.

Gegenüber den vorstehend beschriebenen Werkzeugen zur Übertragung von periodischen Mikrostrukturen auf vorzugsweise optische Oberflächen sind Stahlwerkzeuge bekannt, die mit einer hochtemperaturbeständigen, keramischen Hartstoffschicht beschichtet sind. Durch geeignete Wahl der Schichtabscheideparameter weisen diese Schichten eine Oberflächentopographie auf, die den vorstehend gestellten Anforderungen bezüglich des Aspektverhältnisses sowie der lateralen Dimensionen der Mikrostrukturen im Prinzip erfüllen, jedoch nicht die regelmäßige, periodische Anordnung von Oberflächenstrukturen wie bei den vorstehend genannten Nickel-Masterstempeln aufweisen.

Aufgrund der Nichtperiodizität der in den keramischen Hartstoffschichten einbringbaren Mikrostrukturen werden diese Oberflächenstrukturen als stochastische Oberflächenstrukturen bezeichnet. Bei derartigen stochastischen Oberflächenstrukturen ist nicht nur die laterale Anordnung der einzelnen Strukturelemente in der keramischen Hartstoffschicht unregelmäßig , es ist außerdem in der Ausbildung der Größe der einzelnen Strukturelemente eine relativ breite Verteilung zu beobachten. Das Vorhandensein größerer Strukturelemente innerhalb der Mikrostrukturoberfiäche führt jedoch bei ihrer Abformung zu einer unerwünschten Erhöhung der diffusen Reflexion bei gleichzeitiger Verringerung der direkten Reflexion. Siehe hierzu: A. Gombert, W. Glaubitt, K. Rose, J. Dreibholz, B. Bläsi, A. Heinzel, D. Sporn, W. Döll, V. Wittwer, »Subwavelength-structured antireflective surfaces on glass«, Thin solid Films 351 (1999), No1-2, P. 73-78

Aus dem Artikel von Sakamoto et al., "Fabrication of a micro-patterned diamond film by site-selective plasma chemical vapor deposition", Thin Solid Films, Elsevier-Sequoia S.A. Lausanne, CH, Bd. 334, Nr. 1-2,4. Dezember 1998 (1998-12-04), Seiten 161-164, ISSN: 0040-6090, geht ein Verfahren zur selektiven Beschichtung von Substraten mit einer Diamantschicht hervor. Derartige mit Diamantschichtstrukturen versehen Substrate dienen in der Technik zu vielversprechenden Anwendungen, wie bspw. in der Mikro-Elektronik zur Verwendung in Feldeffekttransistoren. Um selektive Diamantablagerungen mit Strukturdimensionen im Sub-µm-Bereich zu erhalten, macht man sich die Eigenschaft von Diamant zu Nutze, das sich auf einer Platinschicht etwa mit einer 10⁴ größeren Affinität ablagert als bspw. auf einer SiO₂ Oberfläche. Sorgt man dafür, dass auf einer Substratoberfläche geeignete Platinstrukturen aufgebracht sind, so bedarf es lediglich einer ganzflächigen PVD-Beschichtung des derart vorstrukturierten SiO₂-Substrates mit Diamant, das sich lediglich an den Pt-Strukturbreichen nennenswert niederschlägt. Das mit dieser Methode gewonnene, selektiv diamantbeschichtete Substrat genügt jedoch den in der Mikroelektronik vorhandenen Wünschen, gestattet es jedoch aufgrund der gezielt selektiv vorgenommenen Beschichtung nicht als hitzebeständiges Werkzeug in dem eingangs erläuterten Sinne eingesetzt zu werden.

### Darstellung der Erfindung

Der Erfindung liegt die Aufgabe zugrunde, ein Verfahren zur Herstellung eines Werkzeuges sowie ein Werkzeug selbst anzugeben, das zur Schaffung optisch wirksamer Oberflächenstrukturen im sub-µm Bereich einsetzbar ist, mit einer Trägeroberfläche, auf der mittels Materialabscheidung über die Trägeroberfläche erhabene Oberflächenstrukturen aufgebracht werden, derart weiterzubilden, dass einerseits die bei den vorstehend beschriebenen stochastischen Oberflächenstrukturen auftretenden Nachteile, d. h. eine unerwünscht hohe diffuse sowie direkte Reflexion, zu vermeiden, aber dennoch die Einsetzbarkeit des Werkzeuges unter hohen Temperaturen zu gewährleisten, um damit nicht nur optische oder technische Oberflächen aus organischen sondern auch aus anorganischen Materialien wie Glas entspiegeln zu können.

Die Lösung der der Erfindung zugrundeliegenden Aufgabe ist im Anspruch 1 angegeben, indem ein erfindungsgemäßes Verfahren beschrieben ist. Gegenstand des Anspruchs 12 ist ein erfindungsgemäßes Werkzeug, das ebenso wie das erfindungsgemäße Verfahren durch die Merkmale in den Unteransprüchen vorteilhaft weitergebildet wird. Überdies sind der Beschreibung unter Bezugnahme auf die Zeichnungen den Erfindungsgedanken vorteilhaft weiterbildende Merkmale zu entnehmen.

Erfindungsgemäß wird ein Verfahren zur Herstellung eines Werkzeuges offenbart, das zur Schaffung optisch wirksamer Oberflächenstrukturen im sub-µm Bereich verwendbar ist, mit einer auf eine beabsichtigte, makroskopische Kontur bearbeitete oder geformteTrägeroberfläche, auf der mittels Materialabscheidung über die Trägeroberfläche erhabene Oberflächenstrukturen aufgebracht werden, derart ausgebildet, dass die Trägeroberfläche unmittelbar mit einer Maske kontaktiert wird, in der Öffnungen mit Durchmessern im sub-µm Bereich vorgesehen oder einbringbar sind. Anschließend wird die Trägeroberfläche samt Maske einem Beschichtungsprozess unterzogen, bei dem sich Schichtmaterial auch durch die Öffnungen der Maske hindurch auf der Trägeroberfläche abscheidet. Bei Erreichen eines Teilbetrages einer mittleren Endstrukturhöhe der gewünschten Oberflächenstrukturen wird die Maske von der Trägeroberfläche entfernt und anschließend der Beschichtungsvorgang ohne Maske fortgeführt. Hierbei dienen die unmittelbar nach Entfernen der Maske gebildeten Teiloberflächenstrukturen als Wachstums- oder Kristallisationskeime für den weiteren Beschichtungsvorgang, durch den zwar bevorzugt an den Kristallisationskeimen, aber auch zwischen den Oberflächenstrukturen eine Materialablagerung und weiteres Kristallitwachstum erfolgt. Somit wird auf der gesamten Trägeroberfäche Schichtmaterial abegschieden.

Ein besonders günstiger Zeitpunkt, die Maske von der Trägeroberfläche zu entfernen ist erreicht, wenn die sich ausbildenden Oberflächenstrukturelemente etwa 0,5 % bis 80 % ihrer gewünschten Endstrukturhöhe erreicht haben.

Durch die Zweiteilung des Beschichtungsvorganges werden aufgrund der nachfolgenden, bevorzugten Materialabscheidung auf den Beschichtungskeimen einzelne Oberflächenstrukturelemente gewonnen, deren laterale Strukturdimensionen mit zunehmender Strukturhöhe abnehmen. Auf diese Weise entstehen als Oberflächenstrukturen auf der Trägeroberfläche säulenähnliche Gebilde mit abnehmenden Durchmessern. Strukturüberhänge können auf diese Weise vollständig vermieden werden, so dass die Übertragung der Oberflächenstruktur auf optische oder technische Oberflächen im Wege eines Abformvorganges problemlos möglich ist.

Die Anordnung, mit der die einzelnen Oberflächenstrukturelemente auf der Trägeroberfläche abgeschieden werden, ist durch die Anordnung der Öffnungen innerhalb der Maske festgelegt. Im einfachsten Fall dient eine übliche Photoresist-Lackschicht, die zunächst homogen auf die Trägeroberfläche aufgebracht wird, als Maskenmaterial. Mit Hilfe geeigneter photolithographischer Belichtungstechniken können in Abhängigkeit der Belichtungsmuster Öffnungen beliebiger Größe und Verteilung in der photoempfindlichen Lackschicht einbelichtet werden.

Eine andere Möglichkeit die gewünschte Maske herzustellen, sieht die Verwendung einer wässrigen Suspension vor, in der kolloidale, kugelförmige Partikel, dispergiert sind und die auf die Trägeroberfläche aufgetragen wird. Nach einem Eintrocknungsprozess bilden die an der Trägeroberfläche verbleibenden kolloidalen Partikel die Maskenschicht, wobei die zwischen den Partikeln klaffenden Lücken den Öffnungen entsprechen, durch die hindurch eine, die vorstehend beschriebenen Oberflächenstrukturelemente bildende Materialabscheidung erfolgen kann. Weitere Einzelheiten zur Herstellung einer derartigen Maskenschicht sind aus den nachstehenden Beschreibungsteilen unter Bezugnahme auf die Figuren zu entnehmen.

Als Materialien zur Ausbildung der Oberflächenstruktur eignen sich besonders die folgenden Elemente: Ti, Al, Zr, Cr, Mo, Ni, W, Si, B sowie C, sowie auch Elementmischungen aus den vorstehend aufgelisteten Elementbeispielen. Ferner kann wenigstens eines der die Schicht bildenden Elemente wenigstens anteilig oxidiert oder nitriert sein.

Als Materialien zur Bildung von Kristallisationskeimen im ersten Beschichtungsabschnitt eigen sich neben den obengenannten Elementen insbesondere auch Ag, Au, Pd, Pt.

Mit Hilfe einer derartigen Beschichtung ist die Herstellung einer Hochtemperaturbeständigen Schicht möglich, die selbst Temperaturen bis über 850°C standhalten und eine Abformung der Oberflächenstruktur auf optische oder technische Oberflächen ermöglicht, die nicht nur aus organischen, vorzugsweise lichttransparenten, Kunststoffen bestehen, sondern insbesondere auch aus anorganischen Materialien, wie Glas, zusammengesetzt sind.

### Kurze Beschreibung der Erfindung

Die Erfindung wird nachstehend ohne Beschränkung des allgemeinen Erfindungsgedankens anhand von Ausführungsbeispielen unter Bezugnahme auf die Zeichnung exemplarisch beschrieben. Es zeigen:
- Fig. 1a bis d: schematische Darstellung zur Herstellung von Oberflächenstrukturen auf einer Trägeroberfläche,
- Fig. 2: Darstellung zur Anordnung der Oberflächenstrukturelemente auf der Trägeroberfläche, sowie
- Fig. 3: Querschnittsdarstellung durch eine beschichtete Trägeroberfläche mit Oberflächenstrukturetementen,
- Fig. 4a bis c: Herstellung einer Maske aus kolloidalen Partikeln und ihre Verwendung als Maske zur Aufbringung von Beschichtungskeimen

### Wege zur Ausführung der Erfindung, gewerbliche Verwendbarkeit

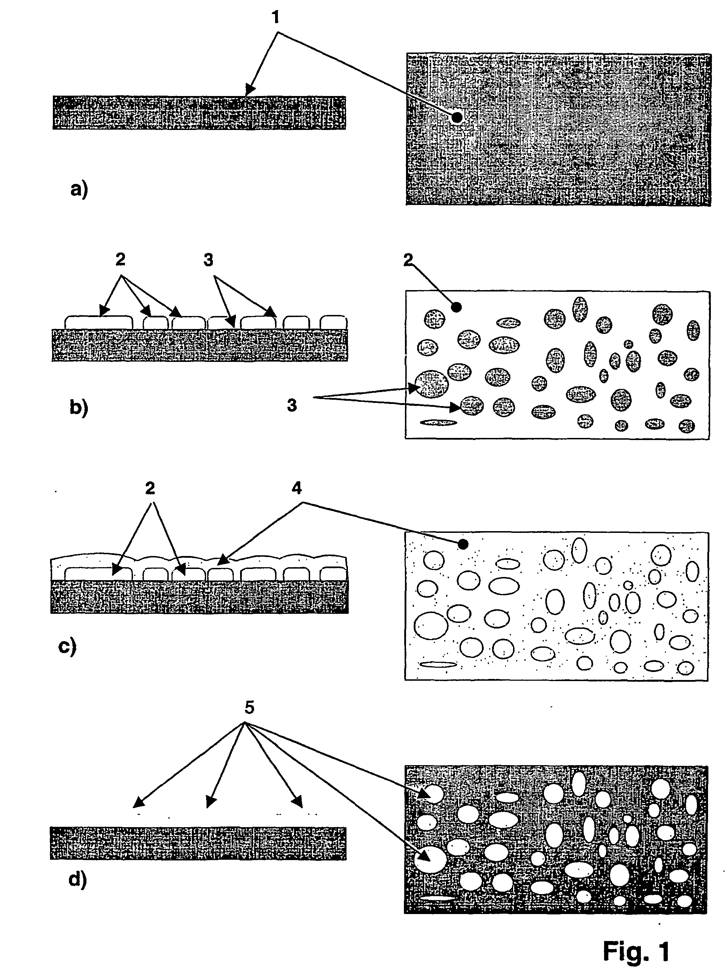

Die in Fig. 1 a bis d dargestellten Bilder zeigen in ihrer jeweiligen linken Darstellung die Seitenansicht und in ihrer rechten Darstellung die Draufsicht eines jeweiligen Verfahrensschrittes. So sind in Fig. 1 a Seiten- und Draufsicht des Trägers eines Werkzeuges dargestellt, mit einer Trägeroberfläche 1, die es gilt, im weiteren gezielt zu beschichten. In Fig. 1 b ist eine Maske 2 unmittelbar auf der Trägeroberfläche 1 aufgebracht, die eine Vielzahl von Öffnungen 3 vorsieht, an denen die Trägeroberfläche 1 freibleibend vom Material der Maske 2 umgeben ist. Das Maskenmaterial 2 kann beispielsweise aus einem Photoresistlack bestehen, der nach entsprechender Belichtung und nachfolgendem Ätzverfahren an den Stellen der Öffnungen 3 lokal und selektiv abgetragen wird. Je nach Belichtungsweise können sich Öffnungen 3 in bestimmter Anordnung innerhalb der Maske 2 ausbilden. Ein Beispiel von Öffnungsgeometrien sowie eine diesbezügliche Anordnung ist aus der Draufsicht der Fig. 1 b zu entnehmen. Die Öffnungen 3 stellen dunkle Bereiche auf der Trägeroberfläche dar, die übrigen Bereiche sind von dem Maskenmaterial 2, hier weiße Bereiche, abgedeckt.

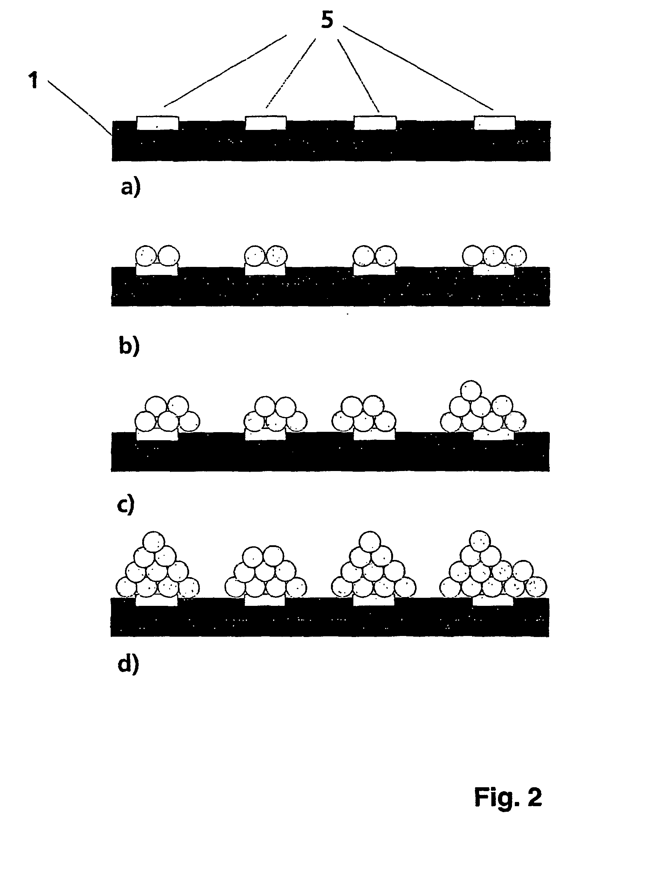

Die mit den Öffnungen 3 versehene Maske 2 wird nun in einem nachfolgenden Beschichtungsvorgang, bei dem insbesondere Hochtemperaturbeständige Materialien abgeschieden werden, vorzugsweise mit Hilfe eines PVD-Prozesses, beschichtet. In Fig. 1 c werden die Maske 2 sowie die Öffnungen 3 vom Schichtmaterial 4 überdeckt, das sich insbesondere innerhalb der Öffnungen 3 unmittelbar auf der Trägeroberfläche 1 abscheidet. Die Beschichtung der Trägeroberfläche 1 sowie der Maske 2 kann unterbrochen werden, sobald die Schichthöhe innerhalb der Öffnungen 3 eine Höhe erreicht hat, die etwa 0,5 bis 80% der projektierten mittleren Endstrukturhöhe der einzelnen Oberflächenstrukturelemente entspricht. Ist eine derartige Schichtdicke erreicht, so wird mit Hilfe selektiver Ätztechnik die Maske 2 sowie die die Maske 2 überdeckende Schicht 4 von der Trägeroberfläche 1 entfernt. Zurück bleiben die Materialabscheidungen 5 als einzelne Oberflächenstrukturelemente, die sich innerhalb der Öffnungen 3 unmittelbar auf der Trägeroberfläche abgeschieden haben. Aus Fig. 1 d geht dies sowohl aus der Seiten- sowie auch aus der Draufsicht hervor. Nachfolgend wird der Beschichtungsprozess fortgeführt, wobei, wie in Figur 2 veranschaulicht, die auf der Trägeroberfläche 1 nach Ablösen der Maske verbliebenen Oberflächenstrukturelemente 5 als Beschichtungskeime dienen. Im weiteren Verlauf des Beschichtungsvorgangs wird Schichtmaterial auf der gesamten Trägeroberfläche, aber mit bevorzugtem Wachstum der einzelnen Strukturgebilde im Bereich der Keime abgeschieden..

Die mit Hilfe des vorstehend beschriebenen Verfahrens erzeugbaren Oberflächenstrukturen weisen typischerweise, je nach Ausbildung der Öffnungen 3 innerhalb der Maske 2, 6 bis 400 Oberflächenstrukturelemente pro µm² auf. Die einzelnen Strukturelemente sind überdies typischerweise zwischen 50 und 400 nm voneinander beabstandet.

Besonders gute optische Eigenschaften können gewonnen werden, wenn die Oberflächenstruktur einzelne Oberflächenstrukturelemente aufweist, deren jeweilige Formen und Größen sich in mindestens zwei unterschiedliche Oberflächenstrukturelementgruppen unterteilen lassen. Grundsätzlich sind die Strukturelemente der einen Gruppe größer ausgebildet als die der anderen Gruppe. Ferner sind die lateralen Abstände der Mittelpunkte der einzelnen Strukturelemente um mindestens zwei charakteristische, mittlere Abstände, M1 und M2, verteilt. Für diese mittleren Abstände haben sich folgende Verhältnisse als besonders vorteilhaft erwiesen: der Wert von M₁ sollte im Bereich zwischen 50 nm und 180 nm liegen, wohingegen der mittlere Abstand M₂ Werte zwischen 200 nm und 400 nm aufweist. Besonders gute Ergebnisse ergeben sich beispielsweise mit M₁ = 170 nm und M₂ = 300 nm. Ferner hat sich herauskristallisiert, dass das Verhältnis aus M₂ und M₁ vorzugsweise gößer 1,1 und kleiner 8 ausfallen soll, insbesondere 1,72 betragen soll.

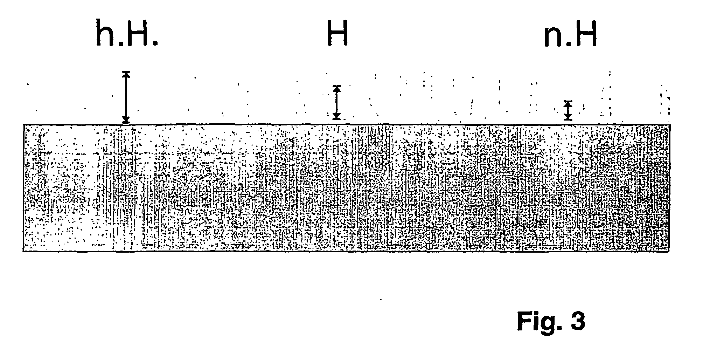

In Fig. 3 ist ein Querschnitt durch ein Werkzeug mit einer Trägeroberfläche 1 dargestellt, das vorzugsweise aus einem metallischen Werkstoff, insbesondere aus einem Stahl oder aus keramischen Werkstoffen oder aus Silizium gefertigt sein kann. Auf der Trägeroberfläche 1 sind eine Vielzahl einzelner Oberflächenstrukturelemente 5 abgeschieden, die säulenartig und nach oben hin verjüngend ausgebildet sind. Zwischen den einzelnen Oberflächenstrukturelementen 5 sind ebenfalls in unterschiedlicher Beschichtungshöhe Materialablagerungen, die von dem den fortgesetzten Beschichtungsvorgang herrühren, vorgesehen. Die Oberflächenstrukturelemente weisen vorzugsweise solche Höhen auf, deren höchste Höhen h.H., bezogen auf die sie jeweils umgebende unterste Schichthöhe, sich um weniger als den Faktor 1,6 von den niedrigsten Oberflächenstrukturelementen n.H. in der Schicht unterscheiden. Die einzelnen Oberflächenstrukturelemente 5 weisen ferner vorzugsweise Strukturhöhen H auf, die zwischen 50 und 1000 nm liegen.

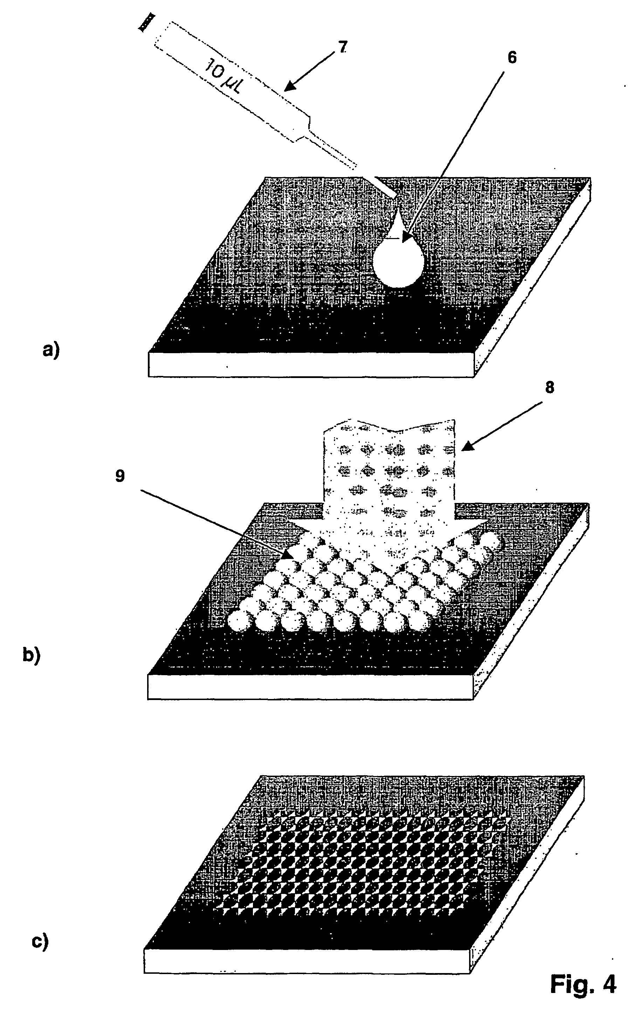

In Fig. 4 ist ein altematives Maskierungs- und Beschichtungsverfahren zu dem in Fig.1 beschriebenen Verfahren angegeben. Hierbei erfolgt die Maskierung der Trägeroberfläche 1 vor dem Beschichtungsprozess mittels Aufbringung einer wässrigen Suspension kolloidaler Teilchen6. Die Suspension 6 wird mit Hilfe üblicher Mikrotittervorrichtungen 7 auf die Trägeroberfläche 1 aufgebracht. Nachfolgend erfolgt gemäß Fig. 4b ein Eintrocknungsprozess, der zu einer dicht gepackten, zweidimensionalen Anordnung der Partikel auf der Trägeroberfläche führt. Anschließend erfolgt dann der zur Aufbringung der Kristallisationskeime notwendige Beschichtungsvorgang 8. Dabei decken die auf der Trägeroberfläche 1 verbleibenden kolloidalen Partikel 9 die Trägeroberfläche derart ab, dass sich Lücken zwischen unmittelbar benachbarten kolloidalen Partikeln 9 bilden, die den vorstehend beschriebenen Öffnungen 3 entsprechen. Durch die Größe der Partikel 9 werden sowohl die Abstände als auch die Größe der Öffnungen 3 vorgegeben. Vorzugsweise können die Partikel 9 aus polymeren Materialien oder anorganischen Materialien, wie z.B. Siliziumoxid bestehen und Durchmesser von typischerweise 50 nm bis 50 µm aufweisen. In Fig. 4c ist ein Beschichtungsmuster angegeben, das sich ergibt, nachdem die kolloidalen Partikel beschichtet und entsprechend von der Trägeroberfläche 1 entfernt worden sind.

Die kolloidalen Partikel 9 können dabei derart ausgewählt werden, dass ihre Größen um jeweils einen Mittelwert (hierbei wird eine monomodale Größenverteilung erreicht) oder um mindestens zwei konkrete Werte (hierbei wird eine bimodale Verteilung erreicht) verteilt sind.

Mit Hilfe des erfindungsgemäßen Verfahrens können neuartige Werkzeuge zur Oberflächenstrukturierung technischer bzw. optischer Oberflächen hergestellt werden, die insbesondere Hochtemperaturbeständig sind. Ferner weisen die vorzugsweise auf Stahl aufgebrachten neuen, submikrostrukturierten Hartstoffschichten folgende Vorteile auf: Durch geeignete Wahl des auf die Trägeroberfläche aufzubringenden Materials kann eine Hochtemperaturbeständigkeit erreicht werden, durch die der Einsatz derartiger Formwerkzeuge nicht nur bei organischen Gläsern, sondern auch bei anorganischen Gläsern, beispielsweise Silikatglas, ermöglicht wird.

Der Beschichtungsvorgang ist nicht beschränkt auf ebene Trägeroberflächen. Es können mit Hilfe des erfindungsgemäßen Verfahrens Werkzeugoberflächen mit nahezu beliebigen Konturen beschichtet werden, dadurch können insbesondere entspiegelte, nicht-ebene optische Komponenten, wie beispielsweise Asphären, hergestellt werden.

Eine besondere Variante eines erfindungsgemäß ausgebildeten Werkzeugs sieht vor, die Trägeroberfläche zu strukturieren, bevor sie dem Beschichtungsvorgang in der vorbeschriebenen Weise unterzogen wird. Die Trägeroberfläche wird dabei teilweise oder ganzflächig mit Vertiefungen versehen, deren Durchmesser an der Trägeroberfläche im Bereich zwischen 1µm und 30 µm liegen. Die Vertiefungen erstrecken sich mit etwa den gleichen Dimensionen in das Innere des Trägersubstrats, sodass ein Aspektverhältnis von ewta 1 vorliegt. Die Vertiefungen sind auf der Trägeroberfläche gleichmäßg verteilt und grenzen mit ihren, an der Trägeroberfläche liegenden Umfangsrändem unmittelbar aneinander.

Trift man die vorstehenden Massnahmen, so erhält man unter Zugrundelegung des erfindungsgemäßen Verfahrens nach Fertigstellung ein Werkzeug, mit dem es möglich ist technische Oberflächen herzustellen, die über Schmutz- und/oder Ölabweisende Eigenschaften verfügen.

### Bezugszeichenliste

- 1: Trägeroberfläche
- 2: Maske, Maskenmaterial
- 3: Öffnungen
- 4: Schichtmaterial
- 5: Oberflächenstrukturelemente
- 6: Kolloidale Suspension
- 7: Pipettiervorrichtung
- 8: Ionen- bzw. Teilchenstrom im PVD-Prozess
- 9: Kolloidale Partikel

## Patentansprüche

1. Verfahren zur Herstellung eines Werkzeuges, das zur Schaffung optisch wirksamer Oberflächenstrukturen im sub-µm Bereich verwendbar ist, mit einer Trägeroberfläche auf der mittels Materialabscheidung über die Trägeroberfläche erhabene Oberflächenstrukturen aufgebracht werden,
**dadurch gekennzeichnet, dass** die Trägeroberfläche unmittelbar mit einer Maske kontaktiert wird, in der Öffnungen mit Durchmessern im sub-µm Bereich vorgesehen oder einbringbar sind,
dass die Trägeroberfläche samt Maske einem Beschichtungsprozess ausgesetzt wird, bei dem sich Schichtmaterial durch die Öffnungen der Maske hindurch auf der Trägeroberfläche abscheidet, und
dass die Maske bei Erreichen eines Teilbetrages einer mittleren Endstrukturhöhe der Oberflächenstrukturen von der Trägeroberfläche entfernt und der Beschichtungsvorgang anschließend ohne Maske mit gleichen oder anderen Beschichtungsmaterialien fortgeführt wird, die auf der gesamten Trägeroberfläche abgeschieden werden, so dass sich zwischen den Oberflächenstrukturen Beschichtungsmaterial ablagert.

2. Verfahren nach Anspruch 1,
**dadurch gekennzeichnet, dass** die Entfernung der Maske bei Erreichen von etwa 0,5 % bis 80 % der mittleren Endstrukturhöhe der Oberflächenstrukturen durchgeführt wird.

3. Verfahren nach Anspruch 1 oder 2,
**dadurch gekennzeichnet, dass** die Beschichtung derart durchgeführt wird, dass sich Oberflächenstrukturen herausbilden, deren laterale Strukturdimension mit zunehmenden Abstand von der Trägeroberfläche abnimmt.

4. Verfahren nach einem der Ansprüche 1 bis 3,
**dadurch gekennzeichnet, dass** zur Erzeugung der Öffnungen innerhalb der Maske die Trägeroberfläche mit einer Maskenschicht überdeckt wird und die Maske im Wege eines Photolithographie-, Elektronen- oder Ionenstrahl-Verfahrens sowie unter Verwendung eines selektiven Materialabtrageverfahrens perforiert wird.

5. Verfahren nach Anspruch 4,
**dadurch gekennzeichnet, dass** das Maskenmaterial aus einer Photoresistschicht oder einem Photolack besteht.

6. Verfahren nach einem der Ansprüche 1 bis 3,
**dadurch gekennzeichnet, dass** auf die Trägeroberfläche eine Suspension mit kolloidalen, kugelförmigen Partikeln aufgebracht wird, die nach einem Eintrocknungsprozeß auf der Trägeroberfläche die Maske bilden.

7. Verfahren nach Anspruch 6,
**dadurch gekennzeichnet, dass** die kolloidalen Partikel aus polymeren Materialien oder aus anorganischen Material bestehen und Durchmesser in der Größenordnung von 50 nm bis 50 µm aufweisen.

8. Verfahren nach einem der Ansprüche 1 bis 7,
**dadurch gekennzeichnet, dass** die Maske derart ausgebildet wird, dass eine Flächenverteilung von Öffnungen in der Größenordnung von 6 bis 400 Öffnungen pro 1µm² vorgesehen ist.

9. Verfahren nach einem der Ansprüche 1 bis 8,
**dadurch gekennzeichnet, dass** die Öffnungen etwa zwischen 50 und 400 nm voneinander beabstandet sind.

10. Verfahren nach einem der Ansprüche 1 bis 9,
**dadurch gekennzeichnet, dass** der Beschichtungsprozess ein PVD-Prozess ist, bei dem als Schichtmaterial wenigstens eines der nachfolgenden Elemente verwendet wird:
Ti, Al, Zr, Cr, Mo, Ni, W, Si, B, C.

11. Verfahren nach Anspruch 10,
**dadurch gekennzeichnet, dass** zur Beschichtung der Maske sowie der unmittelbaren Trägeroberfläche alternativ oder zusätzlich die Elemente
Ag, Au, Pd, Pt
zur Bildung von Kristatlisationskeimen eingesetzt werden.

12. Verfahren nach Anspruch 10 oder 11,
**dadurch gekennzeichnet, dass** wenigstens eines der im fortgesetzten Beschichtungsprozess als Beschichtungsmaterial verwendeten Elemente wenigstens anteilig oxidiert oder nitriert ist.

13. Werkzeug zur Oberflächenstrukturierung und Schaffung optisch wirksamer Oberflächenstrukturen im sub-µm Bereich, hergestellt nach einem Verfahren nach den Ansprüchen 1 bis 12, mit einer Trägeroberfläche auf der mittels Materialabscheidung über die Trägeroberfläche erhabene Oberflächenstrukturen aufgebracht sind,
**dadurch gekennzeichnet, dass** auf der Trägeroberfläche, die eben oder nicht eben, insbesondere gekrümmt, ausgebildet ist, eine Schicht aus hochtemperaturbeständigem Material mit über der Trägeroberfläche erhabenen Oberflächenstrukturen aufgebracht ist, die Strukturdimensionen im sub-µm Bereich mit Strukturhöhen zwischen 50 und 1000 nm und mit gegenseitigen Abständen zwischen 50 und 400 nm aufweisen.

14. Werkzeug nach Anspruch 13,
**dadurch gekennzeichnet, dass** die Oberflächenstrukturen nahezu identische Form und Größe aufweisen oder über diskrete Formen und Größen verfügen.

15. Werkzeug nach Anspruch 14,
**dadurch gekennzeichnet, dass** die Oberflächenstrukturen in mindestens zwei diskrete Form- und Größengruppen einteilbar sind, deren Anordnung auf der Trägeroberfläche einer Ordnung unterliegen.

16. Werkzeug nach Anspruch 15,
**dadurch gekennzeichnet, dass** die Mittelpunkte der Oberflächenstrukturen jeweils gegenseitige laterale Abstände aufweisen, die um mindestens zwei charakteristische, mittlere Abstände M₁ und M₂ verteilt sind, wobei für M, und M₂ gilt:
M1 = M2 oder
M₂ > M₁,
mit 50 nm < M₁ < 180nm und 200 nm < M₂ < 400 nm oder
mit M₁ = 170 nm und M₂ = 300 nm oder
mit 1,1 < M₂/M₁ < 8 oder
mit M₂/M₁ = 1,72.

17. Werkzeug nach einem der Ansprüche 13 bis 16,
**dadurch gekennzeichnet, dass** sich das Maß des größten Höhenunterschiedes zwischen der höchsten Oberflächenstruktur und der diese jeweils umgebenden Vertiefung um weniger als einen Faktor 1,6 von dem Maß des kleinsten Höhenunterschiedes zwischen der kleinsten Oberflächenstruktur und der diese jeweils umgebenden Vertiefung unterscheidet.

18. Werkzeug nach einem der Ansprüche 13 bis 17,
**dadurch gekennzeichnet, dass** die Oberflächenstrukturen unterschiedliche Strukturhöhen aufweisen und Erhebungen, gemessen von den sie jeweils umgebenden Vertiefungen, aufweisen, die zwischen 50 und 1000 nm liegen.

19. Werkzeug nach einem der Ansprüche 13 bis 18,
**dadurch gekennzeichnet, dass** die Trägeroberfläche aus Metall, vorzugsweise Stahl oder Edelstahl, aus keramischen Werkstoffen, Quarzglas oder aus Silizium besteht.

20. Werkzeug nach einem der Ansprüche 13 bis 19,
**dadurch gekennzeichnet, dass** die unbeschichtete Trägeroberfläche glatt oder strukturiert ist.

21. Werkzeug nach Anspruch 20,
**dadurch gekennzeichnet, dass** die strukturierte unbeschichtete Trägeroberfläche Vertiefungen aufweist, deren Durchmesser an der Trägeroberfläche sowie deren Tiefenerstreckung im Bereich von 1 µm bis 30 µm liegen.

22. Werkzeug nach Anspruch 21,
**dadurch gekennzeichnet, dass** die Vertiefungen Aspektverhältnisse aufweisen, die in der Größenordnung von 1 liegen.

23. Verwendung des Werkzeuges nach einem der Ansprüche 13 bis 22, als Prägemittel für optische oder technische Oberflächen zur Oberflächenstrukturierung zum Erhalt von antireflektierenden Oberflächen.

24. Verwendung nach Anspruch 23,
**dadurch gekennzeichnet, dass** das Werkzeug bei Temperaturen von über 400 °C einsetzbar ist.

25. Verwendung nach Anspruch 23 oder 24,
**dadurch gekennzeichnet, dass** die zu entspiegelnden optischen oder technischen Oberflächen aus organischen, vorzugsweise lichttransparenten Kunststoffen, oder anorganischen Materialien, wie Glas bestehen.

26. Verwendung nach Anspruch 23
**dadurch gekennzeichnet, dass** ein Werkzeug, dessen Trägeroberfläche gemäß den Ansprüchen 21 oder 22 vorstrukturiert ist, für die Hertsellung Schmutz- und/oder Ölabweisender technischer Oberflächen dient.

## Claims

1. A method for producing a tool which can be used to create optically active surface structures in the sub-µm range, having a support surface onto which relief surface structures are applied over said support surface by means of material deposition, wherein said support surface is directly contacted with a mask in which openings with diameters in the sub-µm range are provided or can be provided,
said support surface including said mask is subjected to a coating process in which the coating material deposits through said openings of said mask onto said support surface, and
said mask is removed from said support surface when a partial amount of an average end structure height of said surface structures is reached and the coating procedure is then continued without said mask using the same coating materials or different coatings materials, which are deposited onto said entire support surface in such a manner that said coating material settles between said surface structures.

2. The method according to claim 1,
wherein said removal of said mask is carried out when approximately 0.5% to 80% of the average end structure height of said surface structures has been reached.

3. The method according to claim 1 or 2,
wherein said coating is carried out in such a manner that surface structures form whose lateral structure dimensions decrease with increasing distance from said support surface.

4. The method according to one of the claims 1 to 3,
wherein, in order to produce said openings inside said mask, said support surface is covered with a mask layer and said mask is perforated using photolithographic, electron beam or ion beam methods as well as a selective material removal method.

5. The method according to claim 4,
wherein the mask material is a photoresist layer or a photosensitive coating.

6. The method according to one of the claims 1 to 3,
wherein a suspension with colloidal, bead-shaped particles which form said mask on said support surface after a drying process is applied onto said support surface.

7. The method according to claim 6,
wherein said colloidal particles are composed of polymer materials or of an inorganic material and have a diameter in the 50nm to 50 µm size range.

8. The method according to one of the claims 1 to 7,
wherein said mask is designed in such a manner that an areal distribution of said openings of 6 to 400 openings per 1µm² is provided.

9. The method according to one of the claims 1 to 8,
wherein said openings are spaced approximately between 50 and 400 nm apart.

10. The method according to one of the claims 1 to 9,
wherein said coating process is a PVD process in which at least one of the following elements is used as the coating material:
Ti, Al, Zr, Cr, Mo, Ni, W, Si, B, C.

11. The method according to claim 10,
wherein for coating said mask and the directly accessible support surface, alternatively or in addition the elements
Ag, Au, Pd, Pt
are utilized for developing crystallization seeds.

12. The method according to claim 10 or 11,
wherein at least one of said elements utilized as said coating material in the continued coating process is at least partially oxidized or nitrated.

13. A tool for surface structuring and fabrication of optically active surface structures in the sub-µm range, produced according to a method according to claims 1 to 12, having a support surface onto which relief surface structures are applied by means of material deposition over said support surface,
wherein applied onto said support surface, which is designed plane or not plane, in particular curved, is a layer of high-temperature resistant material having relief surface structures over said support surface, said surface structures having dimensions in the sub-µm range having heights between 50 and 1000 nm and having distances apart between 50 and 400nm.

14. The tool according to claim 13,
wherein said surface structures have practically the identical shape and size or possess discrete shapes and sizes.

15. The tool according to claim 14,
wherein said surface structures are dividable into at least two discrete shape and size groups the arrangement of which is subject to an order on said support surface.

16. The tool according to claim 15,
wherein the centers of said surface structures each have mutual lateral spacing distributed by at least two characteristic, average distances M₁ and M₂, with for M₁ and M₂ apply:
M₁ = M₂ or
M₂ > M₁,
with 50nm < M₁ < 180nm and 200nm < M₂ <400nm or
with M₁ = 170nm and M₂ = 300 nm or
with 1.1 < M₂/M₁ < 8 or
with M₂/M₁ = 1.72.

17. The tool according to one of the claims 13 to 16,
wherein the magnitude of the greatest difference in height between the highest surface structure and the respective surrounding indentation is less than a factor 1.6 of the magnitude of the smallest difference in height between the smallest surface structure and the respective indentation surrounding it.

18. The tool according to one of the claims 13 to 17,
wherein the surface structures have different structural heights and elevations measured from the respective indentations surrounding them, which lie between 50 and 1000nm.

19. The tool according to one of the claims 13 to 18,
wherein said support surface is made of metal, preferably steel or stainless steel, of ceramic materials, quartz glass or of silicon.

20. The tool according to one of the claims 13 to 19,
wherein the uncoated support surface is smooth or structured.

21. The tool according to claim 20,
wherein said structured uncoated support surface has indentations the diameter of which at said support surface and depth of which lies in the range from 1µm to 30µm.

22. The tool according to claim 21,
wherein said indentations have aspect relationships which lie in the order of magnitude of 1.

23. Use of said tool according to one of the claims 13 to 22 as a stamping means for surface structuring optical or technical surfaces in order to obtain antireflective surfaces.

24. The use according to claim 23,
wherein said tool can be utilized at temperatures above 400°C.

25. The use according to claim 23 or 24,
**wherein** said to-be-antireflective optical or technical surfaces being composed of organic, preferably light-transparent plastics, or inorganic materials, such as glass.

26. The use according to claim 23,
wherein a tool whose support surface is prestructured according to claims 21 or 22 is utilized for fabricating dirt- repelling and/or oil-repelling technical surfaces.

## Revendications

1. Procédé de fabrication d'un outil utilisable à créer des structures superficielles à effet optique dans la gamme de sub-µm, comprenant une surface de substrat, sur laquelle des structures superficielles, saillant, en relief, de la surface de substrat, sont déposées moyennant le dépôt du matériau,
**caractérisé en ce que** la surface de substrat est directement contactée avec un masque, dans lequel des ouvertures aux diamètres dans la gamme de sub-µm sont prévues ou peuvent être formé,
**en ce que** la surface de substrat, y compris le masque, subit un processus de revêtement, au cours duquel du matériau de couche se dépose à travers les ouvertures du masque sur la surface de substrat, et
**en ce que** le masque est enlevé de la surface de substrat, dès qu'une valeur partielle d'une hauteur structurelle finale des structures superficielles est atteinte, et le processus de revêtement est ensuite continué sans masque aux matériaux égaux ou différents, qui sont déposés sur toute la surface de substrat d'une telle manière, que du matériau de revêtement se dépose entre les structures superficielles.

2. Procédé selon la revendication 1,
**caractérisé en ce que** l'enlèvement du masque se fait, quand 0,5 % à 80 % environ de l'hauteur structurelle finale moyenna des structures superficielles sont atteints.

3. Procédé selon la revendications 1 ou 2,
**caractérisé en ce que** le revêtement est réalisé d'une telle manière, que des structures superficielles se forment, dont la dimension structurelle latérale décroît en correspondance avec l'augmentation de l'écart de la surface de substrat.

4. Procédé selon une quelconque des revendications 1 à 3,
**caractérisé en ce que** la surface de substrat est recouvert d'une couche de masque afin de former les ouvertures au-dedans du masque, et **en ce que** le masque est perforé par un processus de photolithographie, à faisceau d'électrons ou à faisceau d'ions, en appliquant un processus d'enlèvement sélectif de matériau.

5. Procédé selon la revendication 4,
**caractérisé en ce que** le matériau de masque consiste en une couche de laque photosensible ou photorésist.

6. Procédé selon une quelconque des revendications 1 à 3,
**caractérisé en ce qu'**une suspension à particules sphériques colloïdales est appliquée sur la surface de substrat, les particules formant le masque sur la surface de substrat après un processus de séchage.

7. Procédé selon la revendication 6,
**caractérisé en ce que** les particules colloïdales consistent en matériaux polymères ou en un matériau inorganique et présentent un diamètre de l'ordre de 50 nm à 50 µm.

8. Procédé selon une quelconque des revendications 1 à 7,
**caractérisé en ce que** le masque est configuré d'une telle façon, qu'une distribution des ouvertures sur l'aire soit créée dans l'ordre de 6 à 400 ouvertures par 1 µm².

9. Procédé selon une quelconque des revendications 1 à 8,
**caractérisé en ce que** les ouvertures sont écartées l'une de l'autre par une distance entre 50 et 400 nm environ.

10. Procédé selon une quelconque des revendications 1 à 9,
**caractérisé en ce que** le processus de revêtement est un processus dit PVD, dans lequel au moins un des éléments suivants est utilisé en tant que matériau de couche:
Ti, Al, Zr, Cr, Mo, Ni, W, Si, B, C.

11. Procédé selon la revendication 10,
**caractérisé en ce que** pour le revêtement du masque et aussi de la surface directe de substrat, les éléments
Ag, Au, Pd, Pt
sont utilisés alternativement ou de façon supplémentaire afin de former des germes cristallins.

12. Procédé selon la revendication 10 ou 11,
**caractérisé en ce qu'**au moins un des éléments utilisés dans le processus continué de revêtement en tant que matériau de revêtement est oxydé ou nitrifié, au moins en fractions.

13. Outil à structurer des surfaces et à créer des structures superficielles à effet optique dans la gamme de sub-µm, fabriqué par un procédé selon les revendications 1 à 12, à une surface de substrat, sur laquelle des structures superficielles, saillant, en relief, de la surface de substrat, moyennant le dépôt de matériau,
**caractérisé en ce qu'**une couche en matériau résistant aux hautes températures est appliquée sur la surface de substrat, qui est configurée sous forme plane ou non-plane, en particulier sous forme incurvée, aux structures, qui font saillie, en relief, de la surface de substrat, ces structures présentant des dimensions de structure dans la gamme de sub-µm aux hauteurs structurelles entre 50 nm et 1000 nm et aux écarts mutuels entre 50 nm et 400 nm.

14. Outil selon la revendication 13,
**caractérisé en ce que** les structures superficielles présentent une forme et taille presque identique ou ont des formes et tailles discrètes.

15. Outil selon la revendication 14,
**caractérisé en ce que** les structures superficielles sont divisibles en au moins deux groupes par forme et taille discrète, dont l'arrangement est défini par un ordre sur la surface de substrat.

16. Outil selon la revendication 15,
**caractérisé en ce que** les centres des structures superficielles ont des écarts latéraux mutuels respectifs, qui sont distribués autour d'au moins deux distances moyennes caractéristiques M₁ et M₂, la relation suivante s'appliquant pour M₁ et M₂:
M₁ = M₂ ou
M₂ > M₁
à 50 nm < M₁ < 180 nm et 200 nm < M₂ < 400 nm ou
à M₁ = 170 nm et M₂ = 300 nm ou
à 1,1 < M₂/M₁ < 8 ou
à M2/M1 = 1,72.

17. Outil selon une quelconque des revendications 13 à 16,
**caractérisé en ce que** le degré de la différence maximale en hauteur entre la structure superficielle la plus supérieure et le creux respectif, l'entourant, est différent, par moins d'un facteur de 1,6, du degré de la plus petite différence en hauteur entre la structure superficielle la plus petite et le creux respectif l'entourant.

18. Outil selon une quelconque des revendications 13 à 17,
**caractérisé en ce que** les structures superficielles présentent des hauteurs structurelles différentes et des reliefs, mesurés à partir les creux respectifs les entourant, qui se trouvent dans la gamme entre 50 et 1000 nm.

19. Outil selon une quelconque des revendications 13 à 18,
**caractérisé en ce que** la surface de substrat consiste en métal, de préférence en acier ou acier fin, en matériaux céramiques, en verre de quartz ou en silicium.

20. Outil selon une quelconque des revendications 13 à 19,
**caractérisé en ce que** la surface de substrat non revêtu est plane ou structurée.

21. Outil selon la revendication 20,
**caractérisé en ce que** la surface de substrat structurée non revêtu présente des creux, dont le diamètre à la surface de substrat et aussi leur étendue en profondeur se trouvent dans la gamme de 1 µma 30 µm.

22. Outil selon la revendication 21,
**caractérisé en ce que** les creux présentent des rapports d'aspect dans la gamme de 1.

23. Emploi de l'outil selon une quelconque des revendications 13 à 22, en tant que moyen d'estampage pour des surfaces optiques ou techniques pour la structuration des surfaces afin d'obtenir des surfaces traitées en anti-reflet.

24. Emploi selon la revendication 23,
**caractérisé en ce que** l'outil est utilisable aux températures en dessus de 400 °C.

25. Emploi selon la revendication 23 ou 24,
**caractérisé en ce que** les surfaces optiques ou techniques, à traiter en anti-reflet, consistent en matières synthétiques organiques, de préférence transparentes à la lumière, ou en matériaux inorganiques comme de verre.

26. Emploi selon la revendication 23,
**caractérisé en ce qu'**un outil, dont la surface de substrat est pré-structurée selon les revendications 21 ou 22, pour la fabrication des surfaces techniques résistantes à la salissure et/ou oléorésistantes.
